# EUROPEAN PATENT SPECIFICATION

(11) **EP 3 772 096 B1**
(45) Date of publication and mention of the grant of the patent: **30.08.2023**
(21) Application number: 19189229.8
(22) Date of filing: 30.07.2019
(51) Int. Cl.: H01L 23/473

(54) **COOLER BODY**
KÜHLERKÖRPER
CORPS DE REFROIDISSEUR

(43) Date of publication of application: 03.02.2021
(73) Proprietor: BRUSA Elektronik AG, 9466 Sennwald (CH)
(72) Inventor: Wendelspiess, Ueli, 9445 Rebstein (CH)
(74) Representative: Rösler Rasch van der Heide & Partner

(56) References cited:
- EP-A1- 2 291 859
- US-A1- 2017 092 565

## Description

### FIELD OF THE INVENTION

The present invention relates to a cooler body which in particular is adapted for cooling electronic structural units or assemblies.

### BACKGROUND OF THE INVENTION

As is known, the power dissipation and hence the heat evolution of electronic assemblies are increasing with the power-related further development of the electronic structural elements. It is true that these components are becoming smaller but their efficiency and hence the heat to be removed are increasing. Furthermore, due to their compactness, these electronic elements are positioned in a smaller space so that once again a higher local heat development results. The power dissipations achieved would be possible only with complicated and bulky cooling bodies when employing fan cooling and are therefore unacceptable. In case of large losses, air cooling therefore clearly reaches its limits.

The new high-performance processors deliver about 70 to 100 W over an area of about 10 cm² and thus achieve a far higher heat flux density. The processor manufacturers predict that a further increase in the waste heat is to be expected in the years ahead. In view of this development, those skilled in the art are considering liquid cooling for such applications. Liquid cooling more effectively dissipates the heat from the electronic assemblies, with the result that a higher power density is possible. Liquid coolers also allow more compact switch cabinets with numerous electronic components and operate very quietly.

An exemplary generic cooling apparatus is disclosed in EP 2 291 859 A1, in which an insert is provided inside a cooling channel, the insert having a plurality of pins forming channels towards a cooler wall and being supplied with coolant via openings in an inclined surface of the inlet which is hit by a coolant flow from the coolant channel.

Specifically in the field of power electronics in automotive applications, more specific for inverter, converter and charger devices for electric vehicles, there is a need for an intense cooling of the electronic components, especially of the switching components like IGBT's or MOSFET's (since these are the components with the highest amount of power loss in such devices and therefore are the main heat sources within these). US 2017/0092565 A1 discloses a micro heat transfer array for cooling of semiconductor devices, the array may comprise microjets, microchannels, fins or integrated microjets and fins.

To realize an effective cooling at an affordable price is difficult because due to physical restrictions liquids like water have to be used as a heat sink in combination with flow channels which provide large exchanging surfaces and produce high heat transfer coefficients. Further construction materials have to be used which provide a high thermal conductivity.

A further demanding requirement is that there has to be direct contact between the electronic component and the cooling system (under avoidance of any air gaps to ensure sufficient heat conductivity) while simultaneously ensuring sufficient electrical insulation and avoiding mechanical stresses acting on the electronic component (e.g. due to vibration or thermal expansion).

Further requirements especially for automotive solutions are that the cooling liquid has to transfer the received heat to the ambient air (via the vehicles radiator) which (in the worst case scenario for which the system has to be designed) can reach high temperatures (e.g. Dubai summer conditions). This leads to higher temperature levels of the cooling liquid compared to non-automotive applications and therefore to higher needed liquid flow rates. Therefore, such cooling systems have an increased need for a low pressure drop design to avoid to high pressure drops due to higher flow velocities.

Due to increased security and maintenance demands (compared to stationary installations) an automotive cooling solution has an increased need for debris insensitivity. In addition, an automotive cooling system solution has to be designed appropriate to series production.

### OBJECT OF THE INVENTION

The invention provides an improved cooler body, which, while being as compact as possible, permits a more effective cooling structure and a simpler design.

A further object of the invention is to provide a cooler body, meeting the demands of cooling of electronic components in the automotive sector as described above.

### SUMMARY OF THE INVENTION

The invention relates to a cooler body, preferably designed for cooling of an electronic element, comprising a contact piece which comprises a contact surface for (thermal) contact to the part to be cooled and a base piece spaced apart from the contact piece by a middle piece in between the contact piece and the base piece. The middle piece comprises separate or individual holes forming multiple rows of parallelly arranged coolant pipes, whereby each pipe extends substantially from the contact piece to the base piece. At least two coolant channels - the channels enabling a flow of coolant (preferably water is to be used as coolant) from a coolant inlet to a coolant outlet- are formed by a sequence of parallel pipes connected by an enclosing surface of the contact piece and an enclosing surface of the base piece in such a way that each of the coolant channels run multiple times from the contact piece to the base piece and vice versa.

Preferably, the cooler body comprises five or more of such coolant channels, for example a number of five to ten coolant channels. As another preferred option, the enclosing surface of the contact piece and the base piece each comprise multiple protrusions arranged successively and spaced apart from another on each enclosing surface, two successive protrusions together with part of the respective enclosing surface (and an end face of the middle piece) forming a cavity or chamber, the cavity connecting a pipe with the subsequent pipe. For example, essentially an enveloping piece (base piece or contact piece) provides chambers between itself and the middle piece by limiting protrusions whereby two neighbors of the parallel pipes lead into each chamber, thus enabling an inflow and a reverse outflow. Preferably, the protrusions are embodied as fin-like structures. Such fin-like structures can be have a straight form, or a waved form or a zig-zag-form and are preferably arranged transverse to an extension direction of the base / contact piece.

Preferably, subsequent pipe rows are offset to each other (with respect to a general or overall flow direction of each channel).

In embodiments with cavities as described above, optionally each cavity connects the exits of all pipes of a row with all entries of the pipes of the subsequent row.

Preferably, the body is made from ceramic, preferably electrically insulating and thermally well conductive ceramic such as aluminium oxide or aluminium nitride. Alternatively, the body is made from metal such as aluminium or copper.

In case of a ceramic body, the body optionally is a monolithic one, preferably manufactured by sintering green ceramic parts (raw material) of the base, middle and contact piece together in one step. Thus, additional assembly steps and thermal interfaces can be avoided.

As an option, the base piece and the contact piece are embodied as parallel plates, whereby preferably an extension direction of the plates defines a general or overall direction of the channels. As another option, the base piece also serves as a contact piece for contacting the part to be cooled.

As another option, the enclosing surface of the contact piece and the enclosing surface of the base piece are facing each other and/or the pipes are arranged at least roughly perpendicular to the enclosing surfaces.

In some embodiments, the base piece and the contact piece comprise stabilizing ribs and/or the contact surface is designed for direct attachment to the part to be cooled.

The invention also relates to a cooler, in particular electronic element cooler, specifically automotive power electronic cooler, comprising a cooler body according to the invention.

The invention also relates to use of a cooler body according to the invention in a power electronics system, in particular in an automotive power electronics system.

### BRIEF DESCRIPTION OF THE DRAWINGS

By way of example only, preferred embodiments of the invention will be described more fully hereinafter with reference to the accompanying figures, wherein:
Figures 1a to 1c show a first embodiment of a cooler body according to the invention;
Figure 2 shows a further embodiment of parts of a cooler body.

### DETAILED DESCRIPTION OF THE DRAWINGS

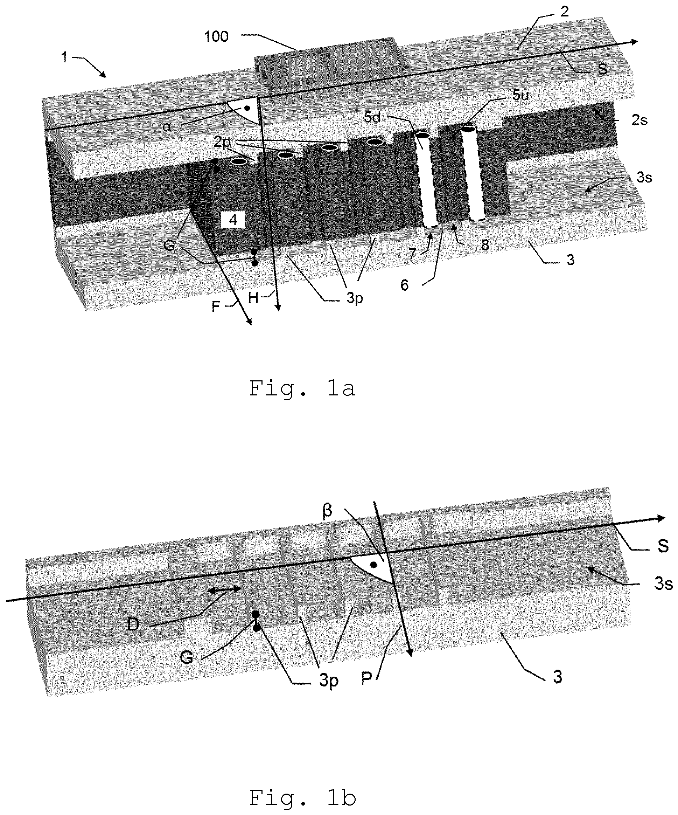

Figure 1a-1c show a first embodiment of a cooler body 1 according to the invention, together with a part 100 to be cooled, e.g. a power electronic element such as a MOS-FET or IGBT, in particular as part of an automotive electronic circuit. As shown in figure 1a in a 3D-view, the cooler body 1 comprises three main parts, a contact piece 2, a middle piece 4 and a base piece 3. The electronic component 100 to be cooled is preferably directly contacted by the contact piece 2, e.g. by a thermal adhesive, a thermal grease or some other interface material with high thermal conductivity.

The body 1 can be made from metal such as aluminum or copper, whereby the three pieces 2, 3, 4 can be made from metal sheets joined together by soldering or brazing. Joining techniques such as sintering can be used as well wherefore an intermediate sinter layer between metal sheets is used. But preferably, the body 1 is made from thermally conductive but electrically insulating ceramic such as aluminium nitride or aluminium oxide, wherefore advantageously there is no need for an additional electric insulation layer. The body 1 preferably is a monolithic body 1. A monolithic ceramic body 1 is e.g. formed by manufacturing the three individual parts 2, 3, 4 first as "green" ceramic parts and then sintering all three parts 2, 3, 4 together in one step. Thus, additional assembly steps and thermal interfaces can be avoided. Alternatively, the base piece 3 and the contact piece 2 are manufactured from two layers of "green" ceramic instead of one. This would simplify the forming process of the unsintered ceramic. In this case preferably some additional ribs are added to stabilize the structure. (The body 1, alternatively, can be metallic and insulations are added for cooling the electronic components.)

The contact piece 2 and the base piece 3 are spaced apart by the middle piece 4 in between. In the example, the contact piece 2 and the base piece 3 embodied as long plates, arranged parallel to each other and extending in a direction S.

The middle piece 4 is in the example embodied as a block, shorter than the plates 2, 3 in extension direction. The middle piece 4 is perforated, the holes 5u, 5d serving a coolant pipes. Thus, the middle piece 4 comprises a multitude of pipes 5u, 5d arranged parallel to each other. The pipes 5d, 5u run from the facing surface 2s of the contact piece 2 to the facing surface 3s of the base piece 3, thereby at least roughly perpendicular to the surface 2s and surface 3s or the angle between the extension direction H of each hole 5u, 5d and the extension direction S of the plates 2, 3 is a right angle (90°).

The three pieces 2, 3, 4 are layered one above the other, forming in the example a sandwich-like structure. As an alternative to the sandwich-like structure shown in the example, wherein the two enclosing surfaces 2s, 3s face each other, the surfaces 2s, 3s are arranged in an angle, e.g. orthogonal, to each other, or are "reversed" parallel to each other, the body 1 then forming a U-like structure. Accordingly, the pipes 5d, 5u then are not straight as shown in figure 1a but angled or formed like a "U". As an option, the base piece 4 is also embodied as a contact piece for thermal contact to the part to be cooled.

The surfaces 2s, 3s facing the pipes 5d, 5u serve as enclosing surfaces. A small gap G is between the middle piece 4 and base piece 3 as well as between middle piece 4 and contact piece 2; or more precisely, there is a gap G between each end of pipes 5u, 5d and each enclosing surface 2s, 3s

Each gap G is established by protrusions 2p, 3p distributed on each enclosing surface 2s, 3s. Said otherwise, there are protrusions 2p, 3p on the inner side 2s, 3s of contact plate 2 and base plate 3 which serve as distance holders to the pipe piece 4 in the middle. The gaps G allow for coolant to enter or exit in the pipes 5u, 5d between the outer pieces 2, 3 and the inner piece 4.

According to the invention, the protrusions 2p, 3p are designed such that they serve as barriers in the longitudinal direction S. Preferably, they are designed as fin-like structures as shown.

For better view of such fin-like protrusions, figure 1b shows only the base plate 3s with fin-like structures 3p on the enclosing surface 3s. The fin-like structures 3p are arranged perpendicular to the extension direction S or the angle β between the extension direction P of each fin 3p and the extension direction S is a right angle or at least roughly 90°.

In the example, the fins 3p are embodied as straight fins. Alternatively, they are wave-like or zig-zag formed. The height of the protrusions 3p define the gap G between enclosing surface 3s and the pipes of the middle piece.

The fins 3p are arranged successively and spaced (equally) apart from each other on the enclosing surface 3s. The distance D between two successive protrusions 3p of a respective piece 2 or 3 is matched to the diameter of the pipes such that is encompasses two successive pipes. The contact piece 2 is designed accordingly, however with an offset of (roughly) one pipe (diameter) with respect to the base piece 3, which is explained in more detail below.

Referring again to figure 1a, it can be seen that thus, two successive protrusions 2p or 3p together with the part of the respective enclosing surface 2s and 3s in between (and an end face of the middle piece 4) form some sort of chamber or cavity 6, with the end 7 of one pipe 5d as a first opening and the end 8 of the following pipe 5u as a second opening. In other words, the cavity 6 connects (the end 7 of) one pipe 5u with (the end 8 of) the subsequent pipe 5d.

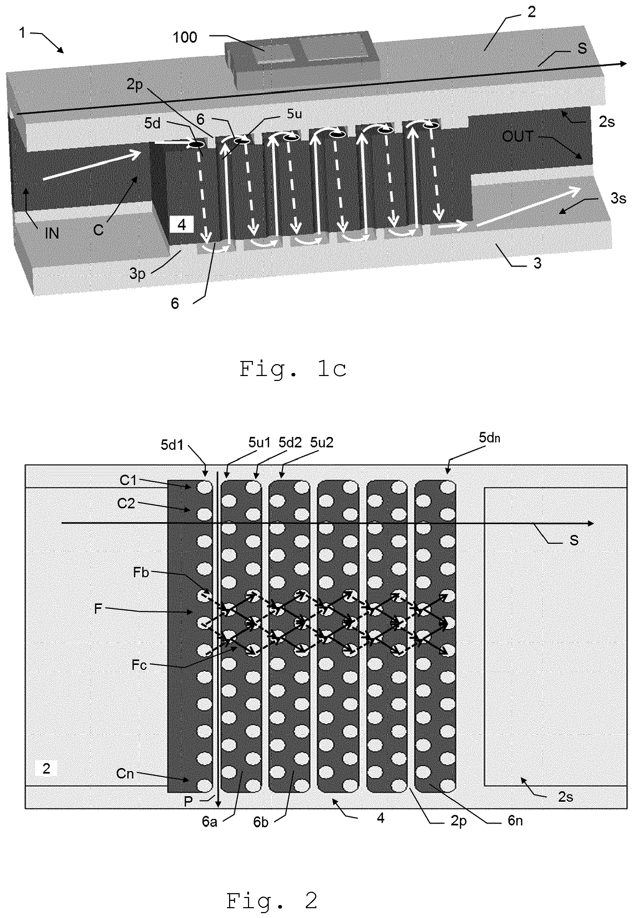

According to the invention, the enclosing surfaces 2s, 3s or more particularly the cavities 6 connect the pipes 5u, 5d such that at least two coolant channels result, from a first pipe 5d, running multiple times from the contact piece 2 to the base piece 3 and vice versa through the pipes 5u, 5d and cavities 6 in between the pipes 5u, 5d. In the exemplary embodiment according to figures 1a-1c, the protrusions 2p and hence the "upper" cavities 6 at the contact piece 2 are at least one pipe (diameter) offset -preferably offset more than one pipe diameter-with respect to the protrusions 3p and hence the "below" cavities 6 at the base piece 3 in extension direction S to achieve this result of directionally alternating channels. Such an alternating channel C is in more detail illustrated in figure 1c.

Figure 1c illustrates schematically in a 3D-view such an alternating coolant channel C according to the invention, indicated by the bright arrows inside the cooler body 1 (for ease of illustration, only one of the two or more channels is explicitly depicted). A coolant (not shown) enters the cooler body 1 respectively a channel C at an inlet IN (in the figure at the left side) in direction of the extension direction S of the cooler body 1. The coolant is first directed at the inner or enclosing surface 2s of the contact piece 2 (indicated by the first two left arrows), where the coolant takes heat from the contact piece 2 respectively the electronics 100.

Then due to a first protrusion 2p of the enclosing surface 2s of the contact piece 2, the channel C runs the first time "down" from the contact piece 2 to the base piece 3 through a first pipe 5d (indicated by the first dashed arrow from the left).

Then, there is a first base piece cavity 6, formed by the enclosing surface 3s with two successive protrusions 3p of the base piece 3, the cavity connecting the end of said first pipe 5d with an end of the pipe 5u following in direction S. Said otherwise, the exit of the first pipe 5d flows into cavity 6 and the base-side opening of the second pipe 5u is exit of cavity 6. The channel C thus is redirected about 180° or in other words makes a U-turn (indicated by the first bent arrow). Thus, the coolant exiting from the first pipe 5d forms an impinging flow on the enclosing surface 2s and enters the second pipe 5u.

The channel C then runs back or "up" to the contact piece 2 according to the second pipe 5u ((indicated by the upwards continuous arrow). The "upwards" pipe 5u leads into contact piece cavity 6 at contact piece 2. Here, the coolant again can take up heat from contact piece 2 respectively electronics 100.

There again, the channel C is redirected about 180° due to cavity 6, leading into a second "downwards" pipe. Said otherwise, the coolant now sinks second time from the contact piece 2 to the base piece 3 through the next pipe of holey middle piece 4. As can be seen, the fin-like structures 2p, 3p of the outer parts 2, 3 separate the coolant between the holes and thus forcing the fluid to return in the next hole.

This "down- and upwards" course from the contact piece 2 to the base piece 3 of channels C is repeated several times (in the example five times). Hence, the structure of the coolant body 1 as suggest provides in a simple and compact way channels C or coolant flow which alternates multiple times between the contact piece 2 and the base piece 3 between inlet IN and outlet OUT of the cooler body 1. The design enables an impact or impingement coolant flow on the contact piece 2 (and base piece 3) and a relatively large contact area between coolant and contact piece 2 resp. surface 2s/3s for heat transfer.

Figure 2 shows a further embodiment according to the invention. Shown is in a bird's eye view the base piece 2 and a cross section of the middle piece 4.

In this embodiment, several parallel channels C1, C2,...Cn with alternating direction between contact piece 2 and base piece 3 as described above are present, provided by rows 5d1, 5u1, 5d2, 5u2, ... 5dN of holes in the middle piece 4. The rows of pipes 5d1, 5u1, 5d2, 5u2, ... 5uN are separated in extension direction (or general direction of the coolant flow F) by base side protrusions 2p, extending along the whole wide of the middle piece 4 in direction P orthogonal to direction S (likewise, but one pipe offset separation is effected by such base side protrusions, not shown in figure 2).

Preferably, the difference between the total number of channels C_{dtotal} (ΣCn @ 5dₙ) at a given pipe row say 5dₙ and the total number of channels at the same pipe row Cᵤₜₒₜₐₗ (ΣCn @ 5uₙ₊₁) is one. The difference between the total number of channels C_{dtotal} (ΣCn @ 5dₙ) at a given pipe row say 5dₙ and the total number of channels of the neighbouring pipe row Cᵤₜₒₜₐₗ (ΣCn @ 5uₙ) is one as well. However, the invention also works with equal number of channels.

By the protrusions 2p, cavities 6a, 6b ... 6n are provided which connect subsequent pipe rows 5u1, 5d2 for redirection of each channel C1...Cn from "upwards" to "downwards". The flow of coolant impinging on the enclosing surface 2s is turned round each time and for each channel C1 ...Cn.

In the exemplary embodiment, the holes are offset in direction S. Said otherwise, only each second pipes row 5d1 ...5dN is positioned equally in direction S. Coolant flowing for example into chamber 6a by a pipe of row 5u1 is distributed into the next two nearest pipes of the subsequent row 5d2 (indicated in the figure by continuous arrows Fc). This is equally effected at the base side (indicated in the figure by dashed arrows Fb), i.e. that same effect is observed on the base side.

Thus, a pipe of for example row 5u1 is not part of only one channel (for example C1), but of two channels (C1 and C2). Due to the offset arrangement of pipe rows 5d1...5uN, each channel C1...Cn is allocated to more than one pipe of each row 5d1...5uN. Therefore, the flow F of a coolant liquid is not only alternating "up" and "down" as described with respect to figures 1a-1c, but in addition alternates (in a far more limited way) in "left" and "right" direction. This pipe or channel arrangement enables a low-turbulent flow F that allows for a high heat transfer at low pressure-drop which enhances heat absorption or release of the coolant.

## Claims

1. A cooler body (1), in particular designed for cooling of an electronic element (100), comprising
o a contact piece (2), comprising a contact surface for contact to the part to be cooled (100),
o a base piece (3) spaced apart from the contact piece (2) by
o a middle piece (4) in between the contact piece (2) and the base piece (3),
whereby
o the middle piece (4) comprises separate holes forming multiple rows of parallelly arranged coolant pipes (5d, 5u, 5d1, 5u1, 5d2, 5u2-5dN),
o each pipe extends substantially from the contact piece (2) to the base piece (3) and
o at least two, in particular at least five, parallel coolant channels (C, C1-Cn) are formed by sequences of parallel pipes (5d, 5u) connected by an enclosing surface (2s) of the contact piece (2) and an enclosing surface (3s) of the base piece (3) in such a way that the at least two coolant channels (C, C1-Cn) each run multiple times from the contact piece (2) to the base piece (3) and vice versa.

2. The cooler body (1) according to claim 1,
**characterized in that**
the enclosing surface (2s) of the contact piece (2) and the enclosing surface (3s) the base piece (3) each comprise multiple protrusions (2p, 3p) arranged successively and spaced apart from another on each enclosing surface (2s, 3s), two successive protrusions (2p, 3p) together with part of the respective enclosing surface (2s, 3s) forming a cavity (6, 6a, 6b), the cavity (6, 6a, 6b) connecting a pipe (5d, 5u) with the subsequent pipe (5u, 5d).

3. The cooler body (1) according to claim 2,
**characterized in that**
the protrusions (2p, 3p) are, in particular straight, waved and/or zig-zag, fin-like structures.

4. The cooler body (1) according to any of the preceding claims,
**characterized in that**
the base piece (3) is designed as a further contact surface for contact to the part to be cooled.

5. The cooler body (1) according to claim 2,
**characterized in that**
each cavity (6a, 6b) connects the exits of all pipes of a row (5u1, 5d2, 5u2-5dN) with all entries of the pipes of the subsequent row (5d2, 5u2-5dN).

6. The cooler body (1) according to any of the preceding claims,
**characterized in that**
subsequent pipe rows (5d1, 5u1, 5d2, 5u2-5dN) are offset to each other.

7. The cooler body (1) according to any of the preceding claims,
**characterized in that**
the body (1) is made from ceramic, in particular aluminium oxide or aluminium nitride

8. The cooler body (1) according to claim 7,
**characterized in that**
the body (1) is a monolithic body, in particular formed by sintering green ceramic parts of the base piece, the middle piece and the contact piece together in one step.

9. The cooler body (1) according to any of the preceding claims,
**characterized in that**
the body (1) is made from metal, in particular aluminium or copper.

10. The cooler body (1) according to any of the preceding claims,
**characterized in that**
the base piece (3) and the contact piece (2) are embodied as parallel plates, in particular wherein an extension direction (S) of the plates defines a general direction of the channels (C, C1-Cn).

11. The cooler body (1) according to any of the preceding claims,
**characterized in that**
o the enclosing surface (2s) of the contact piece (2) and the enclosing surface (3s) of the base piece (3) are facing each other and/or
o the pipes (5d, 5u) are arranged at least roughly perpendicular to the enclosing surfaces (2s, 3s).

12. The cooler body (1) according to any of the preceding claims,
**characterized in that**
the base piece (3) and the contact piece (2) comprise stabilizing ribs.

13. The cooler body (1) according to any of the preceding claims,
**characterized in that**
the contact surface of the contact piece (2) is designed for direct attachment to the part to be cooled.

14. Cooler, in particular electronic element cooler, specifically automotive power electronic cooler, comprising a cooler body (1) according to claim 1.

15. Use of a cooler body (1) according to claim 1 in a power electronics system, in particular in an automotive power electronics system.

## Patentansprüche

1. Kühlerkörper (1), welcher insbesondere für das Kühlen eines elektronischen Bauelements (100) ausgelegt ist, umfassend:
o ein Kontaktstück (2), das eine Kontaktfläche für einen Kontakt mit dem zu kühlenden Teil (100) umfasst,
o ein Basisstück (3), das von dem Kontaktstück (2) beabstandet ist durch
o ein Mittelstück (4) zwischen dem Kontaktstück (2) und dem Basisstück (3),
wobei
o das Mittelstück (4) getrennte Löcher umfasst, die mehrere Reihen von parallel angeordneten Kühlmittelrohren (5d, 5u, 5d1, 5u1, 5d2, 5u2-5dN) bilden,
o jedes Rohr sich im Wesentlichen vom Kontaktstück (2) bis zum Basisstück (3) erstreckt und
o mindestens zwei, insbesondere mindestens fünf parallele Kühlmittelkanäle (C, C1-Cn) von Folgen paralleler Rohre (5d, 5u) gebildet werden, die durch eine Umschließungsfläche (2s) des Kontaktstücks (2) und eine Umschließungsfläche (3s) des Basisstücks (3) auf eine solche Weise verbunden sind, dass die mindestens zwei Kühlmittelkanäle (C, C1-Cn) jeweils mehrere Male vom Kontaktstück (2) zum Basisstück (3) und umgekehrt verlaufen.

2. Kühlerkörper (1) nach Anspruch 1,
**dadurch gekennzeichnet, dass**
die Umschließungsfläche (2s) des Kontaktstücks (2) und die Umschließungsfläche (3s) des Basisstücks (3) jeweils mehrere Vorsprünge (2p, 3p) umfassen, die nacheinander und voneinander beabstandet auf jeder Umschließungsfläche (2s, 3s) angeordnet sind, wobei zwei aufeinander folgende Vorsprünge (2p, 3p) zusammen mit einem Teil der jeweiligen Umschließungsfläche (2s, 3s) einen Hohlraum (6, 6a, 6b) bilden, wobei der Hohlraum (6, 6a, 6b) ein Rohr (5d, 5u) mit dem nachfolgenden Rohr (5u, 5d) verbindet.

3. Kühlerkörper (1) nach Anspruch 2,
**dadurch gekennzeichnet, dass**
die Vorsprünge (2p, 3p) flossenartige, insbesondere gerade, gewellte und/oder zickzackförmige flossenartige Strukturen sind.

4. Kühlerkörper (1) nach einem der vorhergehenden Ansprüche,
**dadurch gekennzeichnet, dass**
das Basisstück (3) als eine weitere Kontaktfläche für einen Kontakt mit dem zu kühlenden Teil ausgebildet ist.

5. Kühlerkörper (1) nach Anspruch 2,
**dadurch gekennzeichnet, dass**
jeder Hohlraum (6a, 6b) die Ausgänge aller Rohre einer Reihe (5u1, 5d2, 5u2-5dN) mit allen Eingänge der Rohre der nachfolgenden Reihe (5d2, 5u2-5dN) verbindet.

6. Kühlerkörper (1) nach einem der vorhergehenden Ansprüche,
**dadurch gekennzeichnet, dass**
aufeinander folgende Rohrreihen (5d1, 5u1, 5d2, 5u2-5dN) zueinander versetzt sind.

7. Kühlerkörper (1) nach einem der vorhergehenden Ansprüche,
**dadurch gekennzeichnet, dass**
der Körper (1) aus Keramik, insbesondere Aluminiumoxid oder Aluminiumnitrid, hergestellt ist.

8. Kühlerkörper (1) nach Anspruch 7,
**dadurch gekennzeichnet, dass**
der Körper (1) ein monolithischer Körper ist, der insbesondere durch Sintern von Rohkeramikteilen des Basisstücks, des Mittelstücks und des Kontaktstücks zusammen in einem Schritt gebildet ist.

9. Kühlerkörper (1) nach einem der vorhergehenden Ansprüche,
**dadurch gekennzeichnet, dass**
der Körper (1) aus Metall, insbesondere Aluminium oder Kupfer, hergestellt ist.

10. Kühlerkörper (1) nach einem der vorhergehenden Ansprüche,
**dadurch gekennzeichnet, dass**
das Basisstück (3) und das Kontaktstück (2) als parallele Platten ausgebildet sind, wobei insbesondere eine Erstreckungsrichtung (S) der Platten eine allgemeine Richtung der Kanäle (C, C1-Cn) definiert.

11. Kühlerkörper (1) nach einem der vorhergehenden Ansprüche,
**dadurch gekennzeichnet, dass**
o die Umschließungsfläche (2s) des Kontaktstücks (2) und die Umschließungsfläche (3s) des Basisstücks (3) einander zugewandt sind, und/oder
o die Rohre (5d, 5u) wenigstens ungefähr senkrecht zu den Umschließungsflächen (2s, 3s) angeordnet sind.

12. Kühlerkörper (1) nach einem der vorhergehenden Ansprüche,
**dadurch gekennzeichnet, dass**
das Basisstück (3) und das Kontaktstück (2) Stabilisierungsrippen umfassen.

13. Kühlerkörper (1) nach einem der vorhergehenden Ansprüche,
**dadurch gekennzeichnet, dass**
die Kontaktfläche des Kontaktstücks (2) für eine direkte Befestigung an dem zu kühlenden Teil ausgelegt ist.

14. Kühler, insbesondere Kühler für elektronische Bauelemente, speziell Kühler für Kraftfahrzeug-Leistungselektronik, welcher einen Kühlerkörper (1) nach Anspruch 1 umfasst.

15. Verwendung eines Kühlerkörpers (1) nach Anspruch 1 in einem leistungselektronischen System, insbesondere in einem leistungselektronischen Kraftfahrzeugsystem.

## Revendications

1. Corps de refroidisseur (1), en particulier conçu pour refroidir un élément électronique (100), comprenant
o une pièce de contact (2) comprenant une surface de contact destinée à venir en contact avec la pièce à refroidir (100),
o une pièce de base (3) espacée de la pièce de contact (2) par
o une pièce médiane (4) entre la pièce de contact (2) et la pièce de base (3),
dans lequel
o la pièce médiane (4) comprend des trous séparés formant de multiples rangées de tuyaux de refroidisseur disposés parallèlement (5d, 5u, 5d1, 5u1, 5d2, 5u2-5dN) ;
o chaque tuyau s'étend sensiblement de la pièce de contact (2) à la pièce de base (3) et
o au moins deux, en particulier au moins cinq, canaux à réfrigérant parallèles (C, C1-Cn) sont formés par des séquences de tuyaux parallèles (5d, 5u) connectés par une surface d'intégration (2s) de la pièce de contact (2) et une surface d'intégration (3s) de la pièce de base (3) de manière à ce que les au moins deux canaux à réfrigérant (C, C1-Cn) aillent de multiples fois de la pièce de contact (2) à la pièce de base (3) et vice versa.

2. Corps de refroidisseur (1) selon la revendication 1,
**caractérisé en ce que**
la surface d'intégration (2s) de la pièce de contact (2) et la surface d'intégration (3s) de la pièce de base (3) comprennent chacune de multiples saillies (2p, 3p) disposées successivement et espacées les unes des autres sur chaque surface d'intégration (2s, 3s), deux saillies successives (2p, 3p) formant avec une partie de la surface d'intégration respective (2s, 3s) une cavité (6, 6a, 6b), la cavité (6, 6a, 6b) connectant un tuyau (5d, 5u) au tuyau suivant (5u, 5d) .

3. Corps de refroidisseur (1) selon la revendication 2,
**caractérisé en ce que**
les saillies (2p, 3p) sont des structures de type ailettes en particulier droites, ondulées et/ou en zigzag.

4. Corps de refroidisseur (1) selon l'une quelconque des revendications précédentes,
**caractérisé en ce que**
la pièce de base (3) est conçue sous forme d'une autre surface de contact destinée à être en contact avec la pièce à refroidir.

5. Corps de refroidisseur (1) selon la revendication 2,
**caractérisé en ce que**
chaque cavité (6a, 6b) connecte les sorties de tous les tuyaux d'une rangée (5u1, 5d2, 5u2-5dN) à toutes les entrées des tuyaux de la rangée consécutive (5d2, 5u2-5dN) .

6. Corps de refroidisseur (1) selon l'une quelconque des revendications précédentes,
**caractérisé en ce que**
les rangées de tuyaux consécutives (5d1, 5u1, 5d2, 5u2-5dN) sont décalées les unes des autres.

7. Corps de refroidisseur (1) selon l'une quelconque des revendications précédentes,
**caractérisé en ce que**
le corps (1) est composé de céramique, en particulier d'oxyde d'aluminium ou de nitrure d'aluminium.

8. Corps de refroidisseur (1) selon la revendication 7,
**caractérisé en ce que**
le corps (1) est un corps monolithique, en particulier formé en frittant des pièces en céramique verte de la pièce de base, de la pièce médiane et de la pièce de contact ensemble en une étape.

9. Corps de refroidisseur (1) selon l'une quelconque des revendications précédentes,
**caractérisé en ce que**
le corps (1) est composé de métal, en particulier d'aluminium ou de cuivre.

10. Corps de refroidisseur (1) selon l'une quelconque des revendications précédentes,
**caractérisé en ce que**
la pièce de base (3) et la pièce de contact (2) sont conformées sous forme de plaques parallèles, un sens d'extension (S) des plaques définissant en particulier un sens général des canaux (C, C1-Cn).

11. Corps de refroidisseur (1) selon l'une quelconque des revendications précédentes,
**caractérisé en ce que**
o la surface d'intégration (2s) de la pièce de contact (2) et la surface d'intégration (3s) de la pièce de base (3) sont opposées l'une à l'autre et/ou
o les tuyaux (5d, 5u) sont disposés au moins approximativement à la perpendiculaire des surfaces d'intégration (2s, 3s).

12. Corps de refroidisseur (1) selon l'une quelconque des revendications précédentes,
**caractérisé en ce que**
la pièce de base (3) et la pièce de contact (2) comprennent des nervures de stabilisation.

13. Corps de refroidisseur (1) selon l'une quelconque des revendications précédentes,
**caractérisé en ce que**
la surface de contact de la pièce de contact (2) est conçue pour diriger la fixation à la pièce à refroidir.

14. Refroidisseur, en particulier refroidisseur à élément électronique, spécialement refroidisseur électronique automobile, comprenant un corps de refroidisseur (1) selon la revendication 1.

15. Utilisation d'un corps de refroidisseur (1) selon la revendication 1 dans un système électronique, en particulier dans un système électronique automobile.
